**Europäisches Patentamt**

**European Patent Office**

**Office européen des brevets**

(19)

(11) Veröffentlichungsnummer : **0 003 977 B1**

# EUROPÄISCHE PATENTSCHRIFT

(12)

(45) Veröffentlichungstag der Patentschrift :
24.11.82

(21) Anmeldenummer : 79100444.3

(22) Anmeldetag : 14.02.79

(51) Int. Cl.³ : **C 23 C 3/02**

(54) Verfahren zum stromlosen Abscheiden von Kupfer.

(30) Priorität : 10.03.78 US 885415

(43) Veröffentlichungstag der Anmeldung :
19.09.79 (Patentblatt 79/19)

(45) Bekanntmachung des Hinweises auf die Patenterteilung : 24.11.82 Patentblatt 82/47

(84) Benannte Vertragsstaaten :
**DE FR GB**

(56) Entgegenhaltungen :
**DE A 2 442 935**
**GB A 905 020**
**GB A 905 047**

**IBM TECHNICAL DISCLOSURE BULLETIN, Vol. 19, Nr. 7, Dezember 1976, BRUENNERT : « Blowing in CO2 free air to stabilize a chemical copper bath »**

(73) Patentinhaber : **International Business Machines Corporation**
**Armonk, N.Y. 10504 (US)**

(72) Erfinder : **Alpaugh, Warren Alan**
**R. D. No. 2, Box 591**
**Chenango Forks NY 13746 (US)**
Erfinder : **Zucconi, Theodore Daniel**
**614 Exchange Ave.**
**Endicott NY 13760 (US)**

(74) Vertreter : **Kreidler, Eva-Maria, Dr. rer. nat.**
**Schönaicher Strasse 220**
**D-7030 Böblingen (DE)**

## Verfahren zum stromlosen Abscheiden von Kupfer

Die Erfindung betrifft ein Verfahren zum stromlosen Abscheiden von Kupfer auf einer katalytisch vorbehandelten Unterlage aus einem Bad mit einem Gehalt an Kupfer(II)ionen, einem Reduktionsmittel, einem oberflächenaktiven Mittel, einem Komplexbildner, Cyanidionen und Sauerstoff, dessen molare Cyanidionenkonzentration in einem Bereich zwischen 0,000 2 und 0,000 4 und dessen Temperatur ständig zwischen 70 und 80 °C gehalten werden.

Verfahren zum stromlosen Abscheiden von Kupfer sind an sich seit langem bekannt. Ein Bad zum stromlosen oder autokatalytischen Plattieren von Kupfer enthält normalerweise ein Kupfer(II)salz, ein Reduktionsmittel für dasselbe, einen Chelat- oder Komplexbildner und einen Bestandteil zur Einstellung des $p_H$-Werts. Zusätzlich wird auf der Oberfläche, auf die plattiert werden soll, wenn diese nicht bereits katalytisch vorbehandelt ist, ein geeigneter Katalysator vor dem Kontakt mit dem Kupferplattierungsbad abgeschieden. Unter den vielfach angewendeten Verfahren zur Katalysierung einer Unterlage ist die Verwendung einer Zinn(II)chlorid-Sensibilisierungslösung und eines Palladiumchloridaktivators üblich zur Ausbildung einer Schicht aus metallischen Palladiumteilchen.

Zusätzlich wird das Bad während des Plattierens im allgemeinen gerührt, um die Badstabilität aufrechtzuerhalten und um Gasblasen aus Wasserstoff abzulösen, die sich vorzugsweise auf der Oberfläche der zu plattierenden Unterlage bilden. Eine Möglichkeit des Rührens besteht darin, ein sauerstoffhaltiges Gas wie Luft, wie es beispielsweise in der US-Patentschrift 2 938 805 beschrieben ist, durch das Bad zu leiten.

Obgleich die Technologie bezüglich der stromlosen Kupferplattierung in den letzten Jahren ständig verbessert wurde, wodurch Kupferüberzüge erhalten wurden, die strenge mechanische Materialprüfungen aushielten, ohne daß sich dabei elektrische oder mechanische Fehler durch Aufreißen ergaben (ein Verfahren dieser Art ist beispielsweise in der deutschen Patentschrift 24 42 935 beschrieben), bleiben doch noch eine Reihe weiterer Probleme übrig. Bestimmte Probleme fallen besonders ins Gewicht, wenn Teile von sehr hoher Qualität, die in der Technologie gedruckter Schaltkreise Anwendung finden, beispielsweise gedruckte Schaltkarten, welche Schaltkreise in hoher Dichte und eine Vielzahl von Öffnungen wie Durchführungsöffnungen und blinde Öffnungen enthalten, hergestellt werden müssen. Die auftretenden Probleme umfassen auch die Ausbildung von Blasen in der Überzügen innerhalb der Durchführungsöffnungen. Dies wiederum kann zu schlechten elektrischen Verbindungen in den Durchführungsöffnungen führen. Zusätzlich bewirken die Blasen in der Überzügen, selbst wenn die elektrischen Verbindungen ursprünglich ausreichend sind, ein Aufreißen der Überzüge während der Anwendung der Schaltkreise. Während des Betriebs neigen integrierte Schaltkreisplatten dazu, sich etwas auszudehnen bzw. zusammenzuziehen. Von irgendwelchen Diskontinuitäten in den Überzügen gehen normalerweise bei mechanischen Spannungen, die durch eine Expansion und Kontraktion dieser Art erzeugt werden, Rissbildungen aus.

Ein wesentlicher Grund für den Ausbeuteverlust beim stromlosen Plattieren ist auch die Ausbildung von abstehendem Kupfer oder Knötchen. Die Ausbildung von Knötchen in unerwünschten Bereichen auf der Unterlage führt zu Kurzschlüssen, indem Kontakte zwischen den einzelnen Leiterzügen auf der Unterlage hergestellt werden. Außerdem werden Prozesse wie die Herstellung von Schutzüberzügen, das Auftragen von Lötflußmitteln und das Einsetzen von Kontaktstiften durch die Anwesenheit von Knötchen auf der Oberfläche nachteilig beeinflußt.

Im Gegensatz hierzu führt das erfindungsgemäße stromlose Kupferplattierungsverfahren zu einer wesentlichen Herabsetzung, wenn nicht Eliminierung der Blasenbildung innerhalb der Durchführungsöffnungen der Unterlage. Außerdem führt das erfindungsgemäße Verfahren zu einer erheblichen Herabsetzung, wenn nicht Eliminierung der Knötchenbildung auf der Oberfläche der Unterlagen.

Bei der Herstellung integrierter Schaltkreise wird im allgemeinen eine erste stromlosen Plattierung von Kupfer aus einem Bad mit hoher Abscheidungsrate vorgenommen, an die sich eine stromlose Plattierung unter Anwendung des Hauptbades oder die galvanische Ausbildung einer Kupferschicht anschließt unter Erhalt eine Schicht der gewünschten Schichtdicke. Das Bad mit der hohen Abscheidungsrate wird hergestellt, um die erste Plattierung von Kupfer auf den katalytisch vorbereiteten Oberflächen zu begünstigen. Üblicherweise werden die Unterlagen solchen Bädern mit hohen Abscheidungsraten etwa eine Stunde lang ausgesetzt und dann in das Hauptbad zum additiven stromlosen Kupferplattieren überführt, wo sie weitere 15 bis 20 Stunden verbleiben. Das Bad mit hoher Abscheidungsrate wird so hergestellt, daß es chemisch viel aktiver ist als das Hauptbad. Die Verwendung eines solchen Bades ist aus ökonomischen Gründen sehr unvorteilhaft, weil für das Beschichtungsverfahren die Herstellung von zwei separaten Bädern erforderlich ist. Weil dieses Bad mit hoher Abscheidungsrate auch chemisch viel aktiver ist als das Hauptbad, ist es schwieriger zu überwachen, was zu dem Ausbeuteverlust an beschichteten Unterlagen noch beiträgt.

Wie bereits oben erwähnt, ist die Verwendung von Sauerstoff in Plattierbädern bekannt. Es wurde jedoch bisher nicht erkannt, daß durch die Einhaltung eines bestimmten Konzentrationsbereichs an gelöstem Sauerstoff in dem Plattierbad Vorteile hinsichtlich der Qualität der Überzüge erhalten werden können. In der Tat führen die Angaben im Stand der Technik über die Verwendung von Sauerstoff weg von der vorliegenden Erfindung.

2

In der US-Patentschrift 2 938 805 ist beispielsweise das Einleiten eines sauerstoffhaltigen Gases, welches mit einem Inertgas wie Stickstoff verdünnt sein kann, in ein Bad zur stromlosen Plattierung von Kupfer beschrieben. Dieser Patentschrift ist jedoch nicht zu entnehmen, daß bestimmte Mengen von gelöstem Sauerstoff in der Badflüssigkeit angewendet werden müssen, um die Vorteile gemäß der Erfindung zu erhalten. Ganz im Gegenteil, dieser Patentschrift ist zu entnehmen, daß keine Vorteile erhalten werden können bei Anwendung eines Gases, welches weniger als 20 Prozent Sauerstoff in Luft enthält (Spalte 3, Zeilen 63 bis 67 der Patentschrift).

In der US-Patentschrift 3 900 599 wird beschrieben, den Sauerstoff so vollständig wie möglich aus dem Plattierbad vor dem Plattieren zu entfernen. Weiterhin ist in Beispiel 2 dieser Patentschrift deutlich zum Ausdruck gebracht, daß ein Rühren unter Anwendung von Luft nicht durchgeführt werden soll zur Vermeidung von Plattierungsfehlern. Dieser Patentschrift ist auch zu entnehmen, daß die angewendeten stromlosen Plattierbäder tatsächlich Bäder mit sehr hoher Abscheidungsrate sind, weil eine anschließende Galvanisierung in Betracht gezogen wird (Spalte 1, Zeilen 65 ff.). Nach den Aussagen in dieser Patentschrift werden die Plattierbäder durch die bloße Anwesenheit von Stickstoff nicht beeinflußt, wohingegen die Verwendung von Stickstoff allein in dem Hauptplattierbad dessen Stabilität nachteilig beeinflussen kann. In den US-Patentschriften 3 900 599 und 3 666 527 und 3 454 416 wird vielmehr angegeben, daß Sauerstoff nicht vorsätzlich oder planmäßig in Verfahren zur stromlosen Plattierung von Kupfer angewendet werden sollte.

In der US-Patentschrift 3 300 335 wird angegeben, das Bad zur stromlosen Plattierung, ehe es mit den zu beschichtenden Unterlagen in Berührung gebracht wird, unter Anwendung eines Gases, welches Luft oder ein Inertgas, wie Stickstoff sein kann, aufzuschäumen. Auch dieser Patentschrift ist nicht zu entnehmen, daß der Sauerstoffgehalt in dem Bereich der vorliegenden Erfindung liegen muß, um die Vorteile der Erfindung zu erhalten.

Eine Abhandlung über die Einwirkung von Sauerstoff auf das Plattieren von Nickel kann beispielsweise in Chemical Abstracts, Vol. 76, Abstract 62385g und Chemical Abstracts, Vol. 72, Abstract 92799e gefunden werden. Weiterhin wird die Anwendung bestimmter leichter Inertgase wie Wasserstoff, Helium, Methan oder Neon bei der stromlosen Plattierung von Nickel in der US-Patentschrift 2 819 188 beschrieben.

Aufgabe der Erfindung ist die Bereitstellung eines Verfahrens zum stromlosen Abscheiden von Kupfer auf einer katalytisch vorbereiteten Unterlage, bei dem Kupferüberzüge auf der Unterlage und in den Durchführungsöffnungen ohne Blasen oder Knötchen erhalten werden können.

Aufgabe der Erfindung ist auch, ein Verfahren anzugeben, bei dem das erste Bad mit hoher Abscheidungsrate in Wegfall kommen kann.

Die Aufgabe der Erfindung wird gelöst durch ein Verfahren der eingangs genannten Art, das in den Ansprüchen gekennzeichnet ist.

Mit dem erfindungsgemäßen Verfahren können Kupferüberzüge ohne Blasen und Knötchen erzeugt werden. Außerdem ist es möglich, bei Anwendung von nur einem Bad sowohl die Plattierung zu initiieren, wie auch ein kontinuierliches Plattierverfahren durchzuführen. Diese Vorteile werden erhalten, ohne daß Nachteile im Hinblick auf die Stabilität des Plattierbades in Kauf genommen werden müssen.

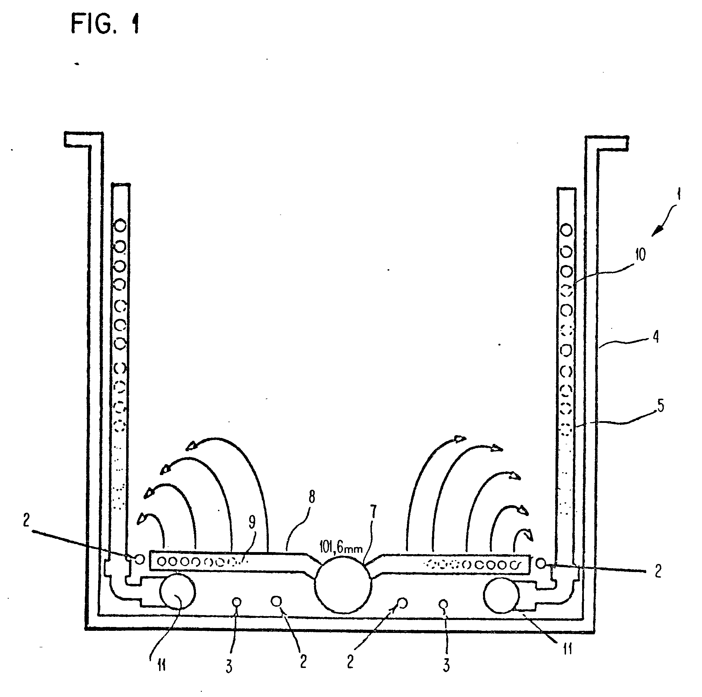

Die Erfindung wird anhand der nachfolgenden speziellen Beschreibung in Verbindung mit Fig. 1 und der Ausführungsbeispiele näher erläutert.

Fig. 1 zeigt eine schematische Darstellung eines Plattiertanks, der zur Durchführung des erfindungsgemäßen Verfahrens geeignet ist.

Es wurde gefunden, daß gemäß der vorliegenden Erfindung verbesserte Produkte erhalten werden können, wenn der Gehalt an gelöstem Sauerstoff in dem Bad während der stromlosen Plattierung von kupfer zwischen 2 und 4 ppm, vorzugsweise zwischen 2,5 und 3,5 ppm gehalten wird. Diese Mengen an gelöstem Sauerstoff liegen unterhalb des Sättigungsgrades von gelöstem Sauerstoff, der bei Anwendung von Luft erhalten wird. Wenn der Gehalt an gelöstem Sauerstoff in diesem Bereich gehalten wird, wird die Ausbildung von Blasen in den Überzügen, insbesondere in den Durchführungsöffnungen der Unterlage wesentlich herabgesetzt, wenn nicht vollständig eliminiert, und die Ausbildung von Knötchen auf der Oberfläche der Unterlage wird auch wesentlich reduziert.

Das Verfahren der vorliegenden Erfindung gestattet auch die Anwendung von nur einem Bad zur Initiierung und anschließenden kontinuierlichen Plattierung der gewünschten Substrate. Damit wird die Verwendung des zusätzlichen Bades mit der hohen Kupferabscheidungsrate überflüssig. Wenn es gewünscht wird, kann natürlich zusätzlich ein solches Bad mit hoher Kupferabscheidungsrate verwendet werden. Durch das Verfahren der vorliegenden Erfindung sind auch kurze Behandlungszeiten (Zeiten zur Plattierung der Überzüge in der gewünschten Dicke in den Durchführungsöffnungen) möglich. So waren beispielsweise Behandlungszeiten in vielen Ausführungsbeispielen gemäß der vorliegenden Erfindung von fünf Minuten oder darunter möglich.

Der gewünschte Gehalt an Sauerstoff während des Plattierens wird dadurch eingestellt, daß in den Plattiertank eine Mischung aus Sauerstoff und Inertgas eingeleitet wird. Die Menge an Sauerstoff in der Mischung wird so gewählt, daß weniger Sauerstoff in der Badflüssigkeit gelöst ist, als wenn das Bad mit Luft allein behandelt würde. Wenn beispielsweise Stickstoff als Inertgas verwendet wird, ist die Menge an Sauerstoff in der Mischung niedriger als normalerweise in Luft.

Der Sauerstoffanteil der Mischung kann von reinem Sauerstoff, oder aus Ersparnisgründen aus der Luft, herrühren. Mit der Luft oder dem Sauerstoff wird ein Inertgas wie Wasserstoff, Stickstoff, Argon, Neon, Krypton oder dergl. gemischt. Stickstoff wird bevorzugt. Es können auch Mischungen von Inertgasen verwendet werden. Die relativen Mengen an Inertgas und Sauerstoff hängen von den relativen Löslichkeiten von Sauerstoff und Inertgas im Wasser bei den angewendeten Badtemperaturen und von dem gewünschten Gehalt an Sauerstoff in der Badflüssigkeit ab. So ergaben beispielsweise bei Stickstoff als Inertgas, gemischt mit Luft und bei Plattiertemperaturen von $73 \pm 0,5$ °C 0,396 m³/Min. Luft pro 3 785 l Badflüssigkeit und 0,019 8 m³/Min. bis 0,028 3 m³/Min. Stickstoff pro 3 785 l Badflüssigkeit Sauerstoffgehalte zwischen 2,5 und 3,5 ppm. Der Sättigungsgrad an Sauerstoff bei 73 °C bei Belüftung des Bades nur mit Luft würde bei etwa 5 bis 5,5 ppm liegen. Der Sättigungsgrad an Sauerstoff nimmt mit zunehmenden Temperaturen ab.

Das Inertgas wird mit dem Sauerstoff oder der Luft vor Einführung in das Bad gemischt. Wenn es gewünscht wird, können die Gase auch separat in das Bad eingeführt werden.

Das Bad zur stromlosen Plattierung von Kupfer, das die gewünschte Sauerstoffmenge gelöst enthält, besteht aus einer wässrigen Zusammensetzung, welche Kupfer(II)ionen, ein Reduktionsmittel, einen Komplexbildner für die Kupfer(II)ionen und einen Bestandteil zur Einstellung des $p_H$-Werts enthält. Die Plattierbäder, die erfindungsgemäß verwendet werden, enthalten auch Cyanidionen und ein oberflächenaktives Mittel.

Kupfer(II)ionen rühren im allgemeinen von Kupfersulfat oder einem Kupfersalz des Komplexbildners, der verwendet wird, her. Wenn Kupfer(II)sulfat angewendet wird, wird es in Mengen von etwa 3 bis 15 g/l und vorzugsweise von etwa 8 bis 12 g/l angewendet. Das gebräuchlichste Reduktionsmittel ist Formaldehyd, welcher in einem vorteilhaften Ausführungsbeispiel der Erfindung in Mengen von etwa 0,7 bis 7 g/l und vorzugsweise in Mengen von 0,7 bis 2,2 g/l angewendet wird. Beispiele für andere Reduktionsmittel schließen Formaldehydvorläufer oder Derivate wie Paraformaldehyd, Trioxan, Dimethylhydantoin oder Glyoxal ; Borhydride wie Alkalimetall-Borhydride (Natrium- und Kaliumborhydrid) und substituierte Borhydride wie Natriumtrimethoxyborhydrid ; Borane wie Aminboran (Isopropylaminboran und Morpholinboran) ein.

Beispiele geeigneter Komplexbilder schließen Kaliumnatriumtartrat (Rochelle-Salz), Äthylendiamintetraessigsäure und die Mono-, Di-, Tri- und Tetranatrium-salze der Äthylendiamintetraessigsäure ; Nitrilotriessigsäure und deren Alkalimetallsalze ; Gluconsäure, Gluconate, Triäthanolamin, Gluconolacton, modifizierte Äthylendiaminacetate wie N-Hydroxyäthyl-äthylendiamin-triacetat ein. Weitere geeignete Komplexbildner werden beispielsweise in den US-Patentschriften 2 996 408, 3 075 856, 3 075 855 und 2 938 805 beschrieben. Die Menge an Komplexbildner hängt von der Menge der Kupfer(II)ionen in der Lösung ab und liegt im allgemeinen zwischen etwa 20 bis 50 g/l, oder bei einem drei- bis vierfachen molaren Überschuß.

Das Plattierbad kann auch ein oberflächenaktives Mittel enthalten, welches die Benetzbarkeit der zu plattierenden Oberfläche erleichtert. Ein geeignetes oberflächenaktives Mittel ist beispielsweise ein organischer Phosphatester, der unter dem Warenzeichen Gafac RE-610 von der General Aniline & Film Corporation erhältlich ist. Das oberflächenaktive Mittel wird im allgemeinen in Mengen von etwa 0,02 bis 0,3 g/l angewendet. Weiterhin wird der $p_H$-Wert des Bades allgemein kontrolliert, beispielsweise durch die Zugabe einer Base wie Natriumhydroxid oder Kaliumhydroxid in den für den gewünschten $p_H$-Wert erforderlichen Mengen. In einem vorteilhaften Ausführungsbeispiel der Erfindung liegt der $p_H$-Wert des stromlosen Plattierbades zwischen 11,6 und 11,8.

In einem Ausführungsbeispiel der Erfindung enthält das Plattierbad Cyanidionen in einer Menge von etwa 10 bis 25 mg/l, wodurch eine Cyanidionenkonzentration der Badflüssigkeit im Bereich von 0,000 2 bis 0,000 4 molar erhalten wird. Beispiele für Cyanide, welche erfindungsgemäß verwendet werden können, sind Alkalimetall-, Erdalkalimetall- und Ammoniumcyanide wie Natrium-, Kalium-, Calcium- und Ammoniumcyanid. Weiterhin können die Plattierbäder in bekannter Weise andere Bestandteile in kleinen Mengen enthalten.

Die Plattierbäder, die erfindungsgemäß verwendet werden, weisen ein spezifisches Gewicht in einem Bereich von 1,060 bis 1,080 auf. Die Badtemperatur wird in dem erfindungsgemäßen Verfahren zwischen 70 und 80 °C und vorzugsweise zwischen 70 und 75 °C gehalten. Die bevorzugten Temperaturen zur Plattierung und die bevorzugten Cyanidionenkonzentrationen sind beispielsweise in der deutschen Patentschrift 24 42 935 beschrieben.

Die Geschwindigkeit des Gasflusses in dem Bad beträgt etwa 0,028 3 m³/Min. bis 0,566 m³/Min. pro 3 785 l Badflüssigkeit und liegt vorzugsweise bei etwa 0,085 bis etwa 0,227 m³/Min. pro 3 785 l Badflüssigkeit. Natürlich kann die Geschwindigkeit des Gasflusses angehoben oder abgesenkt werden in Abhängigkeit von der Größe des Bades. Bei niedrigeren Geschwindigkeiten ist im allgemeinen eine erhöhte Rückführung des Bades erwünscht. Wegen der Anwendung zusätzlicher Mengen an Inertgas kann die Geschwindigkeit des Gasflusses sehr hoch sein, ohne daß der Sauerstoffgehalt erhöht werden muß. Die Anwendung relativ hoher Geschwindigkeiten des Gasflusses sind erwünscht, um eine Instabilität des Bades zu vermeiden. Durch die Anwendung eines Inertgases in Verbindung mit Sauerstoff kann der Sauerstoffgehalt während des ganzen Plattiervorgangs auch während starker Veränderungen im wesentlichen auf einem bestimmten Wert gehalten werden.

Die Plattiergeschwindigkeit, die bei dem erfindungsgemäßen Verfahren erhalten wird, liegt im allgemeinen zwischen etwa 0,001 524 mm bis 0,003 81 mm/h, und die Literbelastung liegt zwischen etwa

4

20 bis etwa 200 cm²/l. Der Sauerstoffgehalt kann in gewissen Abständen oder kontinuierlich gemessen werden unter Anwendung an sich bekannter Vorrichtungen zur Bestimmung des Sauerstoffgehalts.

Wenn der Sauerstoffgehalt unter den gewünschten Bereich abfällt, wird der Gehalt in der Gasmischung so eingestellt, daß der gewünschte Sauerstoffgehalt in der Badflüssigkeit wieder erhalten wird. Wenn beispielsweise der Sauerstoffgehalt unter 2 ppm abfällt, muß die Sauerstoffmenge, welche in die Gasmischung eingeführt wird, erhöht werden, und umgekehrt, wenn der Sauerstoffgehalt 4 ppm übersteigt, muß die Menge an Inertgas, welche in die Gasmischung eingeführt wird, erhöht werden. Die Badflüssigkeit kann auch im Hinblick auf andere Systemparameter ($p_H$-Wert, Temperatur, spezifisches Gewicht, Cyanidionenkonzentration) erforderlichenfalls kontrolliert und entsprechend eingestellt werden.

Das erfindungsgemäße Verfahren kann kontinuierlich durchgeführt werden, indem in dem Bad die verbrauchten Chemikalien ersetzt werden und überlaufende Badflüssigkeit nach ihrer Wiedergewinnung in den Plattiertank rückgeführt wird.

Die nachfolgenden Beispiele und die Tabelle zeigen den Einfluß des Gehalts an gelöstem Sauerstoff auf den Kupferniederschlag an. Epoxidglasfaser-Laminate mit Durchführungsöffnungen, welche mit Zinn(II)chlorid und Palladiumchlorid unter Erhalt eines metallischen Palladiumniederschlags in bestimmten Bereichen sensibilisiert waren, werden in ein Bad zur stromlosen Plattierung mit einem Gehalt an 10 g/l $CuSO_4 \cdot 5H_2O$, 35 g/l Äthylendiamintetraessigsäure-Dihydrat, 0,25 g/l Gafac RE-610, 40 mg/l Natriumcyanid, 2 ml/l 37 prozentigem HCHO und verschiedenen Mengen gelösten Sauerstoffs, die aus der nachfolgenden Tabelle ersichtlich sind, eingeführt. Das spezifische Gewicht des Plattierbades liegt bei 1,07, der $p_H$-Wert durch Zugabe von NaOH bei 11,70, und die Badtemperatur beträgt 73 ± 0,5 °C. Die verschiedenen Gasmischungen, die zum Erhalt der gewünschten Sauerstoffgehalte in das Bad eingeführt werden, werden durch Mischen von Stickstoff mit Luft vor der Einführung in das Bad hergestellt. Die Geschwindigkeit des Gasflusses liegt bei etwa 0,340 m³/Min., wodurch gleichzeitig eine Mischung und eine Bewegung des Bads erreicht wird. Die Plattiergestelle werden während des Plattierens zusätzlich bewegt.

Tabelle I

| Ansatz Nr. | O₂ gelöst, in ppm | Behandlungs- zeit, in Minuten | Blasen | Art des Überzugs |
|---|---|---|---|---|
| 1 | 2,8-3,2 | 5 | Keine | Dick |
| 2 | 3,5 | 5 | Keine | Dick |
| 3 | 3,5-3,7 | 5 | Wenig Blasenbildung | Dünner als in Ansatz 2 |
| 4 | 3,7 | 5 | Wenig Blasenbildung | Etwas dünner als in A. 3 |
| 5 | 4,5 | 20 | Viele Blasen | Dünner Überzug |
| 6 | 2,9 | 5 | Keine | Dick |
| 7 | 2,4 | 5 | Keine | Dick |
| 8 | 2,8 | 10 | Keine | Dick |
| 9 | 2,3 | 5 | Keine | Dick |
| 10 | 3,2 | 5 | Keine | Dick |
| 11 | 3,1 | 5 | Keine | Dick |

Ein Vergleich der Bäder mit Sauerstoffgehalten innerhalb des Bereichs, der erfindungsgemäß beansprucht wird und außerhalb dieses Bereichs in der zuvor angegebenen Tabelle I zeigt die verbesserten Eigenschaften der vorliegenden Erfindung. Im einzelnen waren die Behandlungszeiten sehr viel niedriger, wenn innerhalb des in der vorliegenden Erfindung beanspruchten Bereiches gearbeitet wurde verglichen mit Sauerstoffgehalten außerhalb dieses Bereichs. Weiterhin nimmt die Blasenbildung sehr stark zu, wenn die Mengen an gelöstem Sauerstoff 4 ppm überschreiten. Andererseits wurde gefunden, daß, wenn der Sauerstoffgehalt unter 2 ppm fällt, die Zahl der Knötchen auf der Oberfläche sehr stark zunimmt. Wenn innerhalb des beanspruchten Sauerstoff-Konzentrationsbereichs gearbeitet wird, werden die gewünschten Schichtdicken der Überzüge ohne weiteres erhalten, und es sind auch hohe Plattiergeschwindigkeiten möglich.

Es ist überraschend, daß durch die Zugabe relativ kleiner Mengen eines Inertgases wie Stickstoff im Vergleich mit der Anwendung von Luft allein, ein so beachtlicher Effekt erzielt wird. So ist beispielsweise der Stickstoffgehalt in der Luft etwa 80 Prozent, während, wenn 0,028 3 m³ Stickstoff mit 0,396 m³ Luft gemäß der vorliegenden Erfindung gemischt werden, der Stickstoffgehalt bei etwa 81,35 Prozent liegt, was einer zusätzlichen Menge von 1,35 Prozent und einer Menge von Sauerstoff von 18,65 Prozent entspricht. Die erhaltenen Ergebnisse sind jedoch beachtlich, wie zuvor beschrieben wurde.

In Fig. 1 ist ein Tank 1 dargestellt, der für die Ausführung des erfindungsgemäßen Verfahrens geeignet ist. Der Tank 1 wird durch die Abschlußwände 4 umschlossen. Luft oder Sauerstoff werden in das Bad über die Leitungen 2 und eine Vormischung aus Stickstoff und Luft über die Leitungen 3 zugeführt. Weiterhin ist der Tank mit einer Chemikalien-Zuführvorrichtung 8 versehen, welche eine Rohrleitung 7 für die Einführung von Chemikalien enthält und Öffnungen 9 für den Austritt der Chemikalien in den Tank. Auch abgebildet sind Rückführvorrichtungen 5, die eine Vielzahl von Öffnungen 10 enthalten, durch die die Chemikalien aus dem Bad entfernt und über die Leitungen 11 zu einer nicht abgebildeten Filtervorrichtung geführt werden. Das Material kann nach dem Filtrieren gesammelt und über die Leitung 7 wieder in den Tank zurückgeführt werden.

### Ansprüche

1. Verfahren zum stromlosen Abscheiden von Kupfer auf einer katalytisch vorbehandelten Unterlage aus einem Bad mit einem Gehalt an Kupfer(II)ionen, einem Reduktionsmittel, einem oberflächenaktiven Mittel, einem Komplexbildner, Cyanidionen und Sauerstoff, dessen molare Cyanidionenkonzentration in einem Bereich zwischen 0,000 2 und 0,000 4 und dessen Temperatur ständig zwischen 70 und 80 °C gehalten werden, dadurch gekennzeichnet, daß während des Plattierens der Gehalt des Bades an gelöstem Sauerstoff auf einem Wert zwischen 2 und 4 ppm gehalten wird.

2. Verfahren nach Anspruch 1, dadurch gekennzeichnet, daß der Gehalt des Bades an gelöstem Sauerstoff auf einem Wert zwischen 2,5 und 3,5 ppm gehalten wird.

3. Verfahren nach Anspruch 1, dadurch gekennzeichnet, daß die Badtemperatur zwischen 70 und 75 °C gehalten wird.

4. Verfahren nach den Ansprüchen 1 und 3, dadurch gekennzeichnet, daß die Badtemperatur auf $73 \pm 0,5$ °C gehalten wird.

5. Verfahren nach Anspruch 1, dadurch gekennzeichnet, daß der $p_H$-Wert des Bades zwischen 11,6 und 11,8 gehalten wird.

6. Verfahren nach einem oder mehreren der Ansprüche 1 bis 5, dadurch gekennzeichnet, daß in das Bad eine Mischung aus Sauerstoff oder einem sauerstoffhaltigen Gas mit einem Inertgas eingeleitet wird und der Sauerstoffgehalt der Mischung so bemessen ist, daß der Sauerstoffgehalt des Bades niedriger liegt als wenn Luft allein eingeleitet würde.

7. Verfahren nach Anspruch 6, dadurch gekennzeichnet, daß die Geschwindigkeit des Gasflusses zwischen 0,028 3 und 0,566 m³/Min., vorzugsweise zwischen 0,085 und 0,227 m³/Min. pro 3 785 l Badflüssigkeit liegt.

8. Verfahren nach den Ansprüchen 6 und 7, dadurch gekennzeichnet, daß als sauerstoffhaltiges Gas Luft und als Inertgas Wasserstoff, Stickstoff, Argon, Neon, Krypton oder Mischungen derselben eingeleitet werden.

9. Verfahren nach einem oder mehreren der Ansprüche 1 bis 8, dadurch gekennzeichnet, daß ein Plattierbad mit einem Gehalt an 3 bis 15 g/l Kupfer(II)ionen, 0,7 bis 7 g/l Reduktionsmittel, 0,02 bis 0,3 g/l oberflächenaktivem Mittel, 20 bis 50 g/l Komplexbildner, 10 bis 25 mg/l Cyanidionen und 2 bis 4 ppm gelöstem Sauerstoff, das einen $p_H$-Wert zwischen 11,6 und 11,8 und ein spezifisches Gewicht zwischen 1,060 und 1,080 aufweist und dessen Temperatur ständig zwischen 70 und 80 °C gehalten wird, angewendet wird.

### Claims

1. Process for electroless deposition of copper on a catalytically preprocessed surface from a copper plating bath, containing copper(II)ions, a reducing agent, a surface-active agent, a complexing agent, cyanide ions and oxygen, whose molar cyanide ion concentration is maintained in a range between 0.000 2 and 0.000 4, and whose temperature is continuously maintained between 70 and 80 °C, characterized in that during the plating process the content of dissolved oxygen in the bath is maintained at a level between 2 and 4 ppm.

2. Process of claim 1, characterized in that the content of dissolved oxygen in the bath is maintained at a level between 2.5 and 3.5 ppm.

3. Process of claim 1, characterized in that the temperature of the bath is maintained between 70 and 75 °C.

4. Process of claims 1 and 3, characterized in that the temperature of the bath is maintained within $\pm 0.5°$ of 73 °C.

5. Process of claim 1, characterized in that the pH-value of the bath is maintained between 11.6 and 11.8.

6. Process of one or several of claims 1 to 5, characterized in that a mixture of oxygen or an oxygen-containing gas with an inert gas is introduced into the bath, and that the oxygen content of the mixture is such that the oxygen content of the bath is lower than if air was introduced into the bath alone.

7. Process of claim 6, characterized in that the flow rate of the gas is between 0.028 3 and 0.566 m³/min. preferably between 0.085 and 0.227 m³/min. per 3 785 l of bath.

8. Process of claims 6 and 7, characterized in that as an oxygen-containing gas air is introduced and as an inert gas hydrogen, nitrogen, argon, neon, krypton, or mixtures thereof are introduced.

9. Process of one or several of claims 1 to 8, characterized in that a plating bath is used containing 3 to 5 grams per liter of copper(II)ions, 0.7 to 7 grams per liter of reducing agent, 0.02 to 0.3 grams per liter of surface-active agent, 20 to 50 grams per liter of complexing agent, 10 to 25 milligram per liter of cyanide ions and 2 to 4 ppm dissolved oxygen, and having a pH value between 11.6 and 11.8 and a specific gravity between 1.060 and 1.080 and whose temperature is continuously maintained between 70 and 80 °C.

## Revendications

1. Procédé pour le dépôt chimique de cuivre sur un support traité au préalable par catalyse à partir d'un bain de placage contenant des ions de cuivre (II), un agent de réduction, un agent tensio-actif, un agent complexant, des ions cyanure et de l'oxygène, et dont la concentration molaire en ions cyanure est maintenue entre 0,000 2 et 0,000 4, et dont la température est constamment maintenue entre 70 et 80 °C, caractérisé en ce que l'on maintient, durant le processus de placage, le contenu d'oxygène dissous dans le bain à une valeur comprise entre 2 et 4 ppm.

2. Procédé selon la revendication 1, caractérisé en ce que la teneur en oxygène dissous dans le bain est maintenue à une valeur comprise entre 2,5 et 3,5 ppm.

3. Procédé selon la revendication 1, caractérisé en ce que la température de bain est maintenue entre 70 et 75 °C.

4. Procédé selon les revendications 1 et 3, caractérisé en ce que la température de bain est maintenue à 73 °C ± 0,5 °C.

5. Procédé selon la revendication 1, caractérisé en ce que la valeur du pH du bain est maintenue entre 11,6 et 11,8.

6. Procédé selon l'une quelconque ou plusieurs des revendications 1 à 5, caractérisé en ce que l'on introduit dans le bain un mélange d'oxygène, ou un gaz contenant de l'oxygène, avec un gaz inerte et en ce que l'on détermine la teneur en oxygène du mélange de telle sorte que la teneur en oxygène du bain est plus faible que si l'on avait uniquement introduit de l'air.

7. Procédé selon la revendication 6, caractérisé en ce que la vitesse du flux de gaz est comprise entre 0,028 3 et 0,566 m³/minute, de préférence entre 0,085 et 0,227 m³/minute par 3 785 l de liquide de bain.

8. Procédé selon les revendications 6 et 7, caractérisé en ce que l'on utilise comme gaz contenant de l'oxygène l'air et comme gaz inerte l'hydrogène, l'azote, l'argon, le néon, le krypton ou des mélanges de ceux-ci.

9. Procédé selon l'une quelconque ou plusieurs des revendications 1 à 8, caractérisé en ce que le bain de placage utilisé contient 3 à 15 g/l de ions cuivre (II), 0,7 à 7 g/l d'agent de réduction, 0,02 à 0,3 g/l d'agent tensio-actif, 20 à 50 g/l d'agent complexant, 10 à 25 mg/l de ions cyanure, et 2 à 4 ppm d'oxygène dissout, ce bain ayant une valeur de pH entre 11,6 et 11,8 et un poids spécifique entre 1,060 et 1,080 et dont la température est maintenue constamment entre 70 et 80 °C.

FIG. 1